Europäisches Patentamt

(19) European Patent Office

Office européen des brevets

(11) Numéro de publication: **0 194 394**
**B1**

(12) **FASCICULE DE BREVET EUROPÉEN**

(45) Date de publication du fascicule du brevet:
07.02.90

(21) Numéro de dépôt: 85402306.6

(22) Date de dépôt: 26.11.85

(51) Int. Cl. 5: **H 03 H   9/17,** H 03 H   9/05,
**H 03 H   9/19**

(54) Résonateur à lame vibrante.

(30) Priorité: 04.12.84 FR 8418587

(43) Date de publication de la demande:
17.09.86 Bulletin 86/38

(45) Mention de la délivrance du brevet:
07.02.90 Bulletin 90/06

(84) Etats contractants désignés:
CH DE GB IT LI SE

(56) Documents cité:
FR-A-1 442 041
FR-A-2 080 814
US-A-3 470 400
US-A-4 445 065

(73) Titulaire: CROUZET
128, Avenue de la République
F-75011 Paris (FR)
Titulaire: OFFICE NATIONAL D'ETUDES ET DE
RECHERCHES AEROSPATIALES(O.N.E.R.A.)
29, avenue de la Division Leclerc
F-92320 Chatillon (Hauts de Seine) (FR)

(72) Inventeur: Fima, Henri
25, rue Jules Védrines
F-26027 Valence Cédex (Drôme) (FR)
Inventeur: Janiaud, Denis
2, avenue du Berry Rés. Les Millepertuis - Bât. E3
F-91940 Les Ulis (Essonne) (FR)

(74) Mandataire: Bloch, Robert
2, square de l'Avenue du Bois
F-75116 Paris (FR)

LIBERGRAF, STOCKHOLM 1990

## Description

La présente invention concerne un résonateur du type à lame, ou poutre, vibrant en flexion, comportant des moyens de fixation à au moins une extrémité, et des moyens de découplage vibratoire, par masse d'inertie, disposés entre la lame et les moyens de fixation, pour éviter le transfert d'énergie mécanique vibratoire entre ladite lame et ses moyens de fixation.

Les résonateurs de ce type sont excités et maintenus en oscillation par des moyens divers, par exemple électromagnétiques, électrostatiques, piézoélectriques, sur l'une de leurs fréquences propres.

De tels résonateurs sont utilisés comme éléments sensibles pour réaliser:

- des capteurs de force, de pression, d'accélération ou de température, lorsqu'on les soumet à des forces axiales,
- des oscillateurs stables,
- des gyromètres ou gyroscopes.

Les qualités finales de ces dispositifs sont d'autant plus grandes que le confinement de l'énergie mécanique vibratoire dans la lame est lui-même très bien réalisé, c'est-à-dire que la dissipation d'énergie aux encastrements est réduite. Ceci peut être obtenu en définissant des structures de découplage efficaces évitant l'évacuation par les supports d'une partie de l'énergie mécanique.

Pour cela de nombreux résonateurs ont déjà été proposés.

Un des premiers montages proposé, tel que décrit dans le brevet américain N° 3 479 536 (NORRIS), ne comporte aucun élément de découplage vibratoire, mais, par contre, prévoit des amincissements des éléments de fixation permettant des rotations autour d'axes parallèles au plan de vibration, pour réduire les contraintes non axiales qui pourraient être créées par un mauvais alignement des supports.

Le même brevet enseigne aussi un découplage vibratoire utilisant une méthode de fixation de la lame vibrante par ses lignes nodales. Cela réduit les pertes d'énergie. Les points de liaison sont réduits au minimum entre la lame et les supports au niveau des lignes nodales, par une découpe particulière du résonateur. Cette liaison matérielle introduit néanmoins une raideur angulaire inévitable et de ce fait elle occasionne et transmet les couples de torsion au niveau des lignes nodales, ce qui entraîne un échange d'énergie avec l'extérieur d'où une certaine perte d'énergie vibratoire. Par ailleurs, ce type de résonateur présente l'inconvénient, lorsqu'il est utilisé pour des capteurs de forces, selon lequel les efforts, transmis à la lame à partir des zones de fixation prévues à chaque extrémité, ne se répartissent pas de façon homogène sur la totalité de la lame, ce qui provoque des déplacements importants des points nodaux de vibration, en fonction des efforts exercés et détériore donc le découplage vibratoire.

Il est également connu de réaliser des résonateurs symétriques, en forme de diapason, constitué de deux lames identiques. En théorie cette configuration est parfaite mais elle nécessite en pratique des ajustements de forme et de masse qui ne sont possibles à réaliser que pour un résonateur à fréquence fixe et ne sont plus envisageables pour les résonateurs ayant un large domaine de fréquences utilisables. Une telle réalisation est proposée dans le brevet américain US-A-4 215 570 (NISSE).

Enfin, un autre moyen de découplage peut être obtenu par effet d'inertie. Il consiste à intercaler des masses d'inertie entre la lame et ses extrémités de fixation. Un découplage de ce type est décrit dans le brevet américain US-A-3 470 400 (WEISBORD), qui préconise d'utiliser deux masses d'inertie, en forme de U, à chaque extrémité de la lame. Ces masses sont par ailleurs, chacune, reliées aux moyens de fixations par l'intermédiaire de deux lamelles souples, fonctionnant en parallélogramme déformable. De ce fait, le découplage est obtenu par le déplacement en translation des masses, selon un mouvement alternatif dans le plan de vibration de la lame et en opposition de phase par rapport à celle-ci.

Ce découplage, à la géométrie complexe, impose des tolérances dimensionnelles très réduites pour éliminer les mouvements parasites complexes des masses. Or ces mouvements se traduisent par des efforts de compression et d'extension sur les lamelles du parallélogramme déformable et donc par des pertes d'énergie non négligeables, transmises vers les points de fixation. Il a été proposé, pour atténuer les sollicitations appliquées aux lamelles de liaison, de diminuer artificiellement la raideur de celles-ci en tractioncompression, en modifiant la structure, par exemple, en intercalant entre les lamelles et les masses d'autres lamelles perpendiculaires aux premières.

La réalisation de tels transducteurs implique un usinage, notamment pratiqué par la technique des ultrasons, qui nécessite plusieurs opérations successives dans lesquelles des outils différents sont utilisés pour ébaucher les découpes, usiner les formes et ajuster les cotes. Ces opérations, qui nécessitent des réglages préalables pour chacun des outils, conduisent à un coût de fabrication très élevé.

L'invention a pour but d'éviter les inconvénients des résonateurs de l'art antérieur, en proposant une géométrie simplifiée qui résout les problèmes de confinement de l'énergie mécanique de la lame vibrante et de la conservation de son coefficient de surtension et qui procure un gain important sur le temps d'usinage et le coût de fabrication sans entraîner une perte des qualités habituellement requises pour de tels résonateurs. A cet effet, l'invention concerne un résonateur du type défini ci-dessus, caractérisé par le fait que chaque masse d'inertie est montée oscillante dans le plan de vibration de la lame, selon un mouvement de rotation autour d'un axe orthogonal au plan de la vibration de la lame et est reliée à ses moyens de fixation par un élément souple.

Le résonateur de l'invention peut comprendre deux masses de découplage solidaires des extrémités de la lame et reliées, chacune, à un élément de fixation, chaque masse étant reliée à l'élément de fixation correspondant par un élément souple en rotation et étant animée d'un mouvement de rotation en réponse au mouvement de vibration de la lame, l'axe de rotation de chaque masse étant perpendiculaire au plan de vibration de la lame et situé au niveau des éléments souples.

Dans une forme de réalisation préférée de l'invention, les masses, dans le plan de vibration de la lame, ont un contour convexe tel que celui d'un rectangle ou d'une ellipse par exemple, et sont agencées pour que leur fréquence propre de résonance soit nettement plus élevée que celle de la lame vibrante.

Ce moyen de découplage est applicable aussi bien à un résonateur fixé par ses deux extrémités qu'à un résonateur fixe par une seule extrémité, l'autre extrémité de la lame restant libre.

Pour certaines applications et dans le but d'éviter les modes propres parasites dus à une masse trop importante, chaque masse peut être elle-même subdivisée en au moins deux masses élémentaires reliées entre elles par un élément souple autorisant les rotations de chaque masse élémentaire dans le plan de vibration de la lame.

Cette conception du découplage d'une lame, vibrant en flexion, selon un mode de résonance propre, au moyen de masses d'inertie compactes, donc rigides, facilite beaucoup le calcul précis du dimensionnement du résonateur et réduit le nombre de paramètres à prendre en compte, ce qui conduit à des tolérances de fabrication peu critiques. Si les masses d'inertie sont au nombre de deux, chacune d'elles est reliée aux éléments de fixation par sa face opposée à la lame au moyen d'un élément souple aligné avec la lame et elle est animée d'un mouvement de rotation en réponse au mouvement vibratoire de la lame, l'axe de rotation des masses étant perpendiculaire au plan de vibration de la lame et situé au centre de rotation de l'élément souple correspondant.

Cette conception permet d'obtenir une préparition uniforme de la contrainte longitudinale, à l'intérieur de la lame, créée par l'effort à mesurer.

S'il n'y a qu'une seule masse d'inertie, subdivisée ou non, comme dans le cas d'une lame ayant une extrémité libre, l'articulation est située entre ladite masse et l'unique moyen de fixation. Comme précédemment, la masse d'inertie oscille dans le plan de vibration de la lame selon un mouvement de rotation autour d'un axe orthogonal au plan de vibration de ladite lame.

Le résonateur de l'invention peut avantageusement être monobloc et obtenu à partir d'un matériau homogène, par exemple du quartz, entretenu sur une de ses fréquences de résonance par effet piézoélectrique. Suivant l'utilisation envisagée, l'élément vibrant pourra être de section rectangulaire, carrée ou circulaire, la section d'une telle lame n'étant pas nécessairement uniforme.

Dans une forme de réalisation préférée du résonateur de l'invention, on utilise une lame de quartz rectangulaire d'épaisseur déterminée et de dimensions correspondant aux cotes extérieures de l'ensemble de la structure. On réalise par ailleurs un outil pour l'usinage, aux ultrasons, aux dimensions des évidements à créer, et donc l'obtention de la configuration de la lame, des masses, des éléments souples et des éléments de fixation. On procède à l'usinage en une seule opération. Le temps d'usinage d'un résonateur selon l'invention, par rapport au temps nécessaire pour usiner une structure aux performances équivalentes, telle que celles décrites ci-dessus, est de dix à quinze fois plus court. En outre les tolérances d'usinage peuvent être plus larges. La structure du résonateur de l'invention peut être définie à partir de calculs simples. L'accessibilité sur les faces de la lame vibrante est facilitée, ce qui simplifie les travaux complémentaires comme le rodage et la métallisation, par exemple pour constituer les électrodes d'excitation piézoélectrique.

L'invention sera mieux comprise à l'aide de la description suivante de plusieurs formes de réalisation préférée de l'invention, en comparaison avec l'état de la technique antérieure, et en référence aux dessins annexés sur lesquels:

Les figures 1 à 4 représentent des vues en perspective de quatre différents résonateurs de l'art antérieur et destinés en particulier à la mesure des efforts;

La figure 5a représente une vue en perspective d'une forme de réalisation du résonateur de l'invention fixé par ses extrémités et destiné principalement aux mesures de forces ou de températures;

La figure 5b représente une autre forme de réalisation du résonateur de l'invention fixé par une seule de ses extrémités et plus spécialement destiné à servir de référence de fréquence ou d'élément sensible de gyromètre;

La figure 6a est un schéma illustrant la position Xn de la force Fō équivalente aux efforts engendrés par la lame du résonateur selon l'invention, encastrée à ses extrémités 6, en mode pair de vibration;

La figure 6b est un schéma analogue à celui de la fig. 6a, pour la même lame, mais en mode impair de vibration;

La figure 6c est un schéma analogue à ceux des fig. 6a et 6b, mais pour une lame encastrée à une extrémité seulement;

La figure 7 est une vue latérale d'une autre forme de réalisation du résonateur de l'invention montrant ses déformations pour les deux positions extrêmes de ses mouvements vibratoires;

La figure 8 illustre dans le cas d'un mode de vibration pair du résonateur des fig. 5a et 6a, d'une part les forces F⃗o exercées par la lame, élément vibrant, et d'autre part les forces R⃗ et les moments de réaction Γ⃗ et − Γ⃗ exercés par l'ensemble du résonateur au niveau des encastrements 7 sur les éléments de fixation 2;

La figure 9a est une vue en perspective du résonateur des fig. 5a et 6a conforme à l'invention, fixé par ses deux extrémités;

La figure 9b est une vue analogue à la fig. 9a, le résonateur étant fixé par une seule extrémité, l'autre extrémité étant libre, et

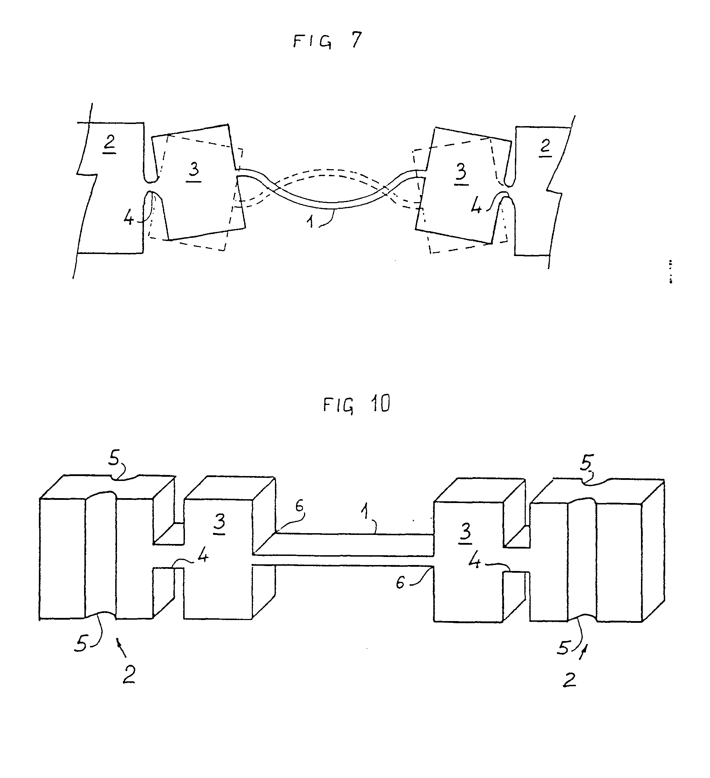

La figure 10 représente une vue en perspective d'une autre forme de réalisation du résonateur conforme à l'invention, dont les moyens de fixation 2 comportent des amincissements du type NORRIS.

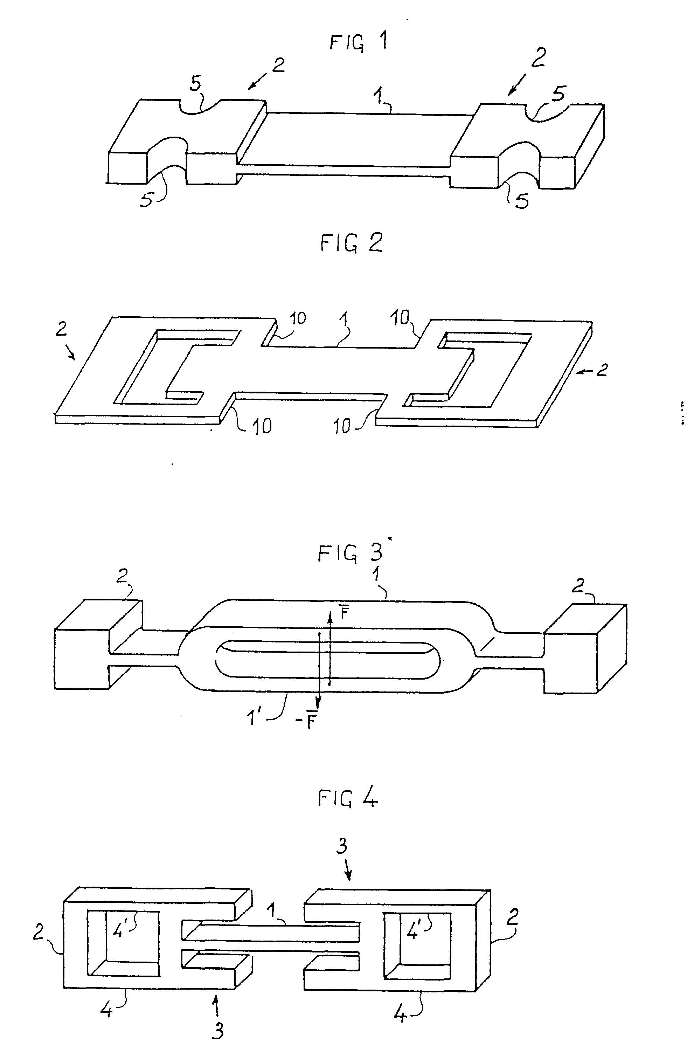

La figure 1 représente un résonateur de NORRIS, comportant un élément vibrant 1, du type lame, et des moyens de fixation 2. Ce résonateur ne comporte aucun élément de découplage vibratoire, mais seulement des amincissements 5 au niveau des fixations 2 permettant de réduire les contraintes non axiales dues à un défaut d'alignement des moyens de fixation.

La figure 2 représente un autre résonateur de NORRIS dont l'élément vibrant 1 est fixé aux extrémités 2 par ses points nodaux 10.

La figure 3 représente un exemple typique de résonateur du type diapason utilisant deux lames 1 et 1', identiques et symétriques, avec deux extrémités 2.

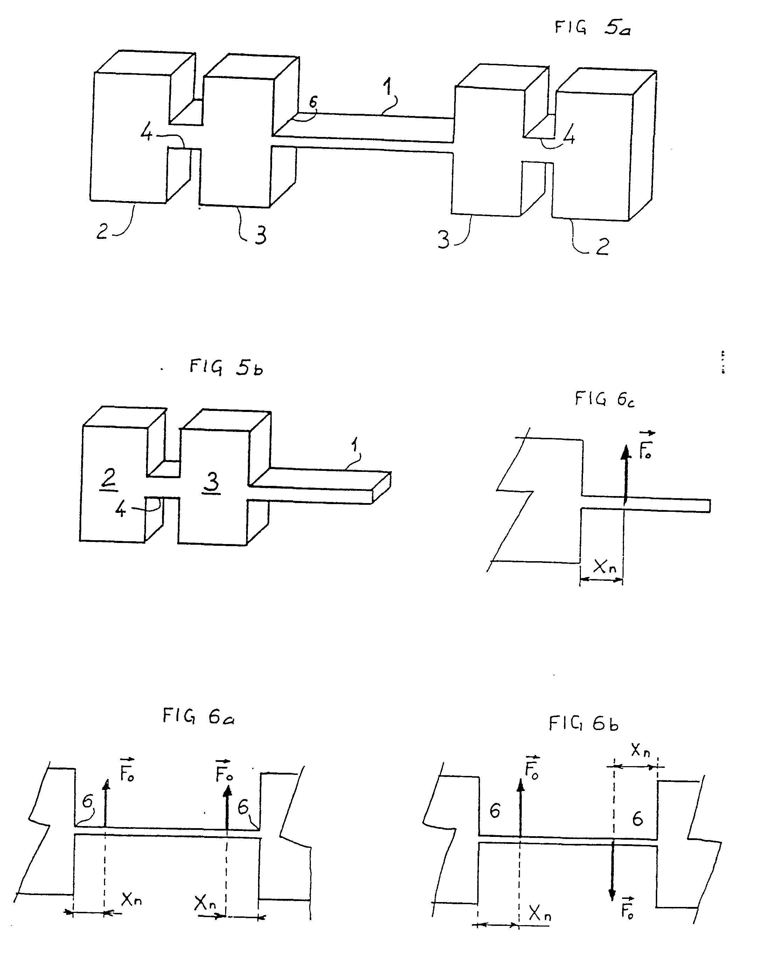

La figure 4 est un résonateur de WEISBORD, dans lequel la réduction des transferts d'énergie vibratoire est obtenue par l'utilisation de masses d'inertie complexes se déplaçant en translation du fait de leur fixation aux supports 2 - par des articulations à lamelles souples et parallèles 4 et 4'.

Suivant l'invention, le résonateur comprend une poutre, ou lame vibrante, 1, des masses d'inertie 3, des éléments souples en rotation, ou des articulations, 4 disposés entre des moyens supports de fixation 2 et les masses 3.

Le découplage mécanique du résonateur de l'invention implique que la lame vibre en flexion, selon un mode de résonance propre, dans un plan contenant l'axe longitudinal de la lame et l'une des deux directions principales d'inertie de sa section droite; ces deux plans de flexion principaux sont orthogonaux. La fixation de la lame est supposée être réalisée par encastrement de l'une ou de ses deux extrémités, le raccordement de la lame aux supports, par l'intermédiaire des masses s'effectuant sur une section droite de ladite lame. Ces encastrements sont repérés par les références 6.

La théorie de la flexion limitée aux petits mouvements permet de déterminer le spectre des fréquences propres de vibration fn. Ce spectre dépend à la fois du plan de flexion principal choisi et des conditions aux limites, c'est-à-dire avec une lame encastrée à ses deux extrémités, telle que sur la figure 5a, ou encastrée à une seule extrémité, l'autre étant libre, telle que sur la figure 5b. Pour un spectre donné, le numéro du mode est repéré par un nombre entier $n$ positif ou nul, avec $n = 0$ pour le mode fondamental. La fréquence fn est une fonction croissante de $n$. D'autre part, on peut déterminer pour chaque mode l'action mécanique exercée par la lame vibrante sur le support, au niveau de la section droite d'encastrement. Le système de forces appliquées est équivalent à une force unique, fonction sinusoïdale du temps, de la forme F⃗o cos $\omega$ nt, $\omega_n$ étant la pulsation du mode $n$ envisagé. Le support du vecteur glissant Fo est perpendiculaire à la lame, situé dans le plan de flexion de la ligne moyenne de la lame, et coupe celle-ci à une distance Xn de l'encastrement 6. Xn dépend des conditions aux limites de la lame et du numéro $n$ du mode.

**a) Cas d'une lame encastrée aux deux extrémités** (figures 6a et 6b)

Pour chacun des deux plans de flexion principaux, les fréquences propres fn forment une suite dont les termes varient comme $(3/2 + n)^2$, soit:

$$fn = \frac{\pi}{2 L^2} \left(\frac{3}{2} + n\right)^2 \quad \sqrt{\frac{EI}{\rho S}} \tag{1}$$

équation dans laquelle:

E représente le module d'Young longitudinal,

ρ représente la masse volumique du matériau de la lame,

I représente le moment d'inertie d'une section droite de la lame par rapport à son axe principal d'inertie perpendiculaire au plan de flexion,

S représente la surface d'une section droite de la lame,

L représente la longueur de la lame

La distance Xn est donnée par l'équation suivante:

$$Xn = \frac{L}{\frac{3\pi}{2} + n\pi} \tag{2}$$

Les deux équations (1) et (2) donnent des valeurs de fn et Xn qui sont approchées mais d'autant plus exactes que $n$ est grand. Ainsi pour $n = 0$, l'équation (2) donne Xo : 0,212 L alors que la valeur exacte est 0,215 L. Pour $n \geq 1$, la valeur calculée de Xn est pratiquement exacte.

Les réactions des encastrements dépendent de la parité du mode de flexion suivant que $n$ est pair ou impair (figure 6a pour un mode pair, figure

6b pour un mode impair).

### b) Cas d'une lame encastrée à une seule extrémité (fig. 6c)

Les valeurs approchées des fréquences propres sont les mêmes que dans le cas précédent, avec addition d'une fréquence supplémentaire correspondant au mode fondamental n = 0. On obtient alors:

$$fo = \frac{(1.875)^2}{2\pi L^2} \sqrt{\frac{EI}{\rho S}}$$

$$\begin{cases} fn \approx \frac{\pi}{2\,L^2}\left(\frac{3}{2} + n - 1\right)^2 \sqrt{\frac{EI}{\rho S}} \\ n \geq 1 \end{cases} \quad (3)$$

On obtient de même, pour la distance Xn:

$$Xo = 0{,}726\,L$$

$$\begin{cases} Xn \approx \dfrac{L}{\dfrac{3\pi}{2} + (n-1)\pi} \\ n \geq 1 \end{cases} \quad (4)$$

A noter que dans le cas d'une lame de section non constante, on calcule, comme indiqué par la suite pour chaque mode de flexion, la fréquence de résonance fn et la distance caractéristique Xn définies précédemment.

### Définition du dispositif de découplage vibratoire

Pour minimiser le bruit et la dérive de fréquence d'un oscillateur à lame vibrante, il est nécessaire de découpler mécaniquement la lame vibrante de son support, en vue d'obtenir un coefficient de qualité suffisant.

Le découplage mécanique le est parfait si les forces et les moments appliqués au support sont nuls, ce qui n'est pas le cas pour une simple lame encastrée, comme on l'a vu ci-dessus.

Selon l'invention, le découplage mécanique est obtenu par un effet d'inertie en interposant, entre la lame 1 et les moyens de fixation 2, des masses rigides 3, c'est-à-dire compactes et à contour convexe, pouvant se déplacer en rotation grâce à des éléments souples 4 faisant office d'articulations articulées autour d'un axe orthogonal au plan de vibration de la lame. Dans le plan de vibration de la lame 1, les masses rigides 3 peuvent avoir la forme d'un rectangle ou d'une ellipse, par exemple.

Ainsi, le découplage d'une lame encastrée aux deux extrémités, par exemple, pour réaliser un capteur de force, est obtenu avec une structure monobloc taillée dans un bloc de quartz parallélépipédique.

Les figures 5 a et 7 représentent un exemple de découpe effectuée selon l'invention.

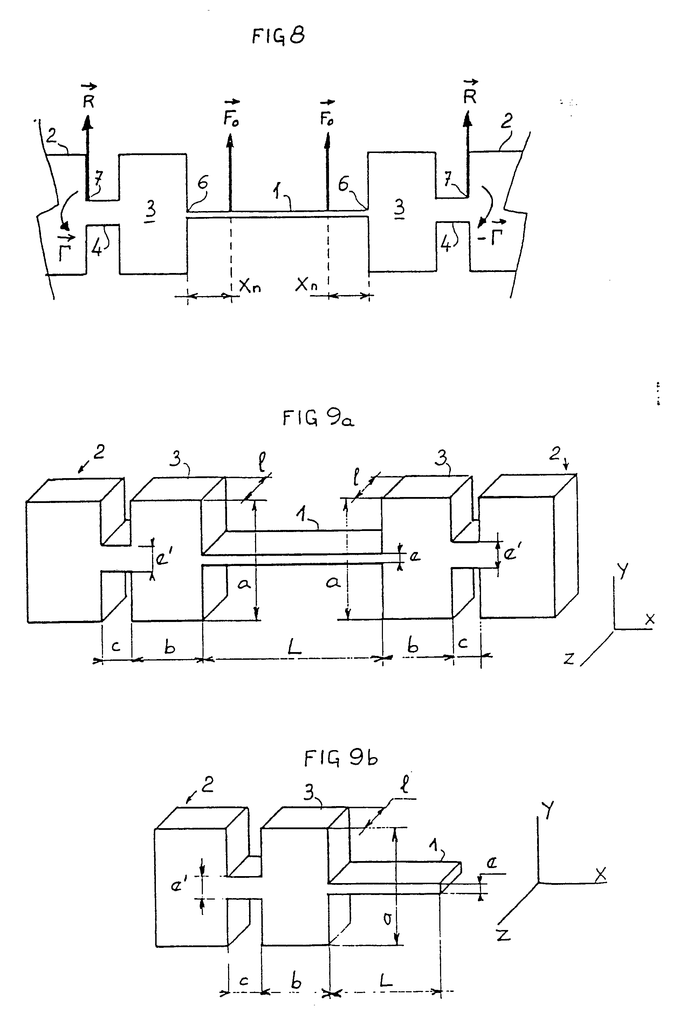

La lame 1 vibre en flexion dans le plan de la figure 7. Elle est encastrée à chaque extrémité dans une masse 3 de forme rectangulaire entraînée en rotation autour d'une articulation souple en forme de barette 4. Les deux parties extrêmes 2 sont les éléments de fixation qui sont, par exemple, collés aux éléments structuraux de l'ensemble de mesure, non représenté pour simplifier les figures. On notera qu'une masse d'inertie peut comporter deux masses élémentaires ou plus reliées entre elles par des éléments souples, autorisant les rotations de chaque masse élémentaire dans le plan de vibration de la lame. On a représenté sur la figure 7, en pointillé et en trait plein, la structure dans sa déformation extrême lorsque la lame 1 - vibre dans le mode fondamental. La déformation de la lame est fortement agrandie ainsi que la rotation relative des masses.

La section de la lame, dans cet exemple, est rectangulaire et constante, le plan de la figure 7 étant alors un plan principal de flexion. La structure est symétrique par rapport au plan médiateur de la lame.

Le principe du découplage consiste à définir judicieusement les dimensions des masses 3 de manière à annuler, sur la section droite de raccordement 7, entre l'articulation 4 et le moyen de fixation 2, la résultante R⃗ de la réaction du support, telle que représentée figure 8. Il subsiste un couple (moment) Γ⃗ non nul, car la raideur angulaire de l'articulation 4 n'est pas nulle.

En pratique, le moment Γ⃗ peut être rendu très petit par rapport au produit Fo. b, b étant la longueur des masses 3, si la fréquence de vibration est grande devant la fréquence de résonance en rotation de la masse 3 autour de l'articulation 4.

D'autre part, pour un mode pair, la somme des couples au niveau des sections est nulle, ce qui annule le torseur des forces appliquées à la structure comprise entre les deux sections 7. Ce qui est le cas pour le mode fondamental de flexion de la lame.

Lorsque la masse d'une masse d'inertie est grande devant la masse de lame, la condition de découplage optimal R = 0 s'exprime par l'équation approchée suivante:

$$\frac{a^2 + b^2}{6(b+c)} = Xn + \frac{b}{2} \quad (5)$$

Xn est la distance caractéristique du mode n choisi pour une lame encastrée aux deux extrémités, comme définie précédemment et a étant la dimension des masses 3 orthogonalement à leur longueur, c étant la longueur de l'articulation 4. Les dimensions a, b, c, sont représentées sur la figure 9a qui montre le résonateur, avec l'orientation des axes cristallographiques X, Y, Z du quartz dans lequel il est taillé.

Les dimensions des éléments de fixation 2 sont sans importance.

Dans le cas de masses d'inertie de forme quelconque et d'une lame de section évolutive le long de son axe longitudinal, la condition de découplage optimal s'exprime par l'équation pratique suivante:

$$\frac{J}{m \cdot Lg} = Xn + d \qquad (6)$$

équation dans laquelle:

J représente le moment d'inertie de la masse par rapport à un axe passant par son centre de gravité et perpendiculaire au plan de flexion,

m représente la masse de la masse d'inertie,

Lg représente la distance du centre de gravité de la masse à l'axe de rotation de la masse,

d représente la distance entre le centre de gravité de la masse d'inertie et l'encastrement 6 de la lame

Dans le cas d'une lame encastrée à une seule extrémité (figures 5b et 9b), le découplage est obtenu par une seule masse 3 puisque la lame est libre à une extrémité. Dans ces conditions, l'équation (5) de découplage optimal est la même que précédemment, Xn correspondant maintenant au mode n d'une poutre encastrée, à une seule extrémité. La figure 9b représente un exemple de réalisation d'une structure découplée pour le mode fondamental de flexion de la lame dans le plan X, Y. La fréquence de résonance est ici obtenue par effet piézoélectrique, est pratiquement la même que pour la structure précédente, compte tenu des dimensions choisies.

Les axes X, Y, Z représentent les axes cristallographiques du bloc de quartz utilisé.

Dans les deux exemples de réalisation décrits et ici, pour un résonateur monobloc taillé dans un bloc ou plaque de quartz d'épaisseur uniforme avantageusement par usinage à ultrasons en une seule opération à l'aide d'un outil unique, et ayant une fréquence du mode fondamental de l'ordre de 50 KHZ en l'absence d'effort longitudinal, le coefficient de qualité obtenu dépasse couramment la valeur de 100 000. Ce facteur de qualité dans le cas du premier exemple est conservé dans une gamme de fréquences très étendue en fonction de l'effort longitudinal appliqué au résonateur.

Le résonateur, objet de l'invention, permet de réaliser économiquement des résonateurs ayant un très bon coefficient de qualité. Il est particulièrement intéressant de l'utiliser comme capteur de force, capteur de pression, capteur de température ainsi qu'élément vibrant pour utilisations gyroscopiques.

## Revendications

1. Résonateur du type à lame, ou poutre, (1), vibrant en flexion, comportant à chaque extrémité des moyens de fixation (2) et dont le découplage vibratoire est obtenu par des masses d'inertie (3) disposées entre les moyens de fixation (2) et la lame (1), caractérisé par le fait que chaque masse d'inertie (3) est montée oscillante dans le plan de vibration de la lame (1) selon un mouvement de rotation autour d'un axe orthogonal au plan de vibration de ladite lame (1) et est reliée à ses moyens de fixation par un élément souple (4).

2. Résonateur selon la revendication 1, caractérisé par le fait que les masses d'inertie (3) sont à contour convexe, sont reliées aux éléments de fixation (2) par leur face opposée à la lame (1) et sont agencées pour être animées d'un mouvement de rotation en réponse au mouvement de vibration de la lame (1), l'axe de rotation des masses (3) étant perpendiculaire au plan de vibration de la lame (1) et situé au niveau d'éléments souples (4).

3. Résonateur du type à lame, ou poutre, (1) vibrant en flexion et ayant une extrémité libre, et dont le découplage vibratoire est obtenu par une masse d'inertie (3), disposée entre un moyen de fixation (2) et la lame (1), caractérisé par le fait que la masse d'inertie (3) est montée oscillante dans le plan de vibration de la lame (1) selon un mouvement de rotation autour d'un axe orthogonal au plan de vibration de ladite lame (1), la masse d'inertie (3) étant reliée au moyen de fixation (2) par un élément souple (4).

4. Résonateur selon l'une des revendications 1 à 3, caractérisé par le fait que la masse d'inertie (3) comporte au moins deux masses élémentaires reliées entre elles par un élément souple autorisant les rotations de chaque masse élémentaire dans le plan de vibration de la lame (1).

5. Résonateur selon l'une des revendications 1 à 4, caractérisé par le fait que la fréquence propre de résonance des masses d'inertie (3) est plus élevée que celle de la lame vibrante (1).

6. Résonateur selon l'une des revendications 1 à 5, caractérisé par le fait que la lame (1) est agencée pour vibrer en mode fondamental de flexion.

7. Résonateur selon l'une des revendications 1 à 5, caractérisé par le fait que la lame (1) est agencée pour vibrer en un mode partiel de flexion.

8. Résonateur selon l'une des revendications 1 à 7, caractérisé par le fait que dans le plan de vibration de la lame (1), les masses d'inertie (3) ont la forme d'un rectangle.

9. Résonateur selon l'une des revendications 1 à 7, caractérisé par le fait que dans le plan de vibration de la lame, les masses d'inertie (3) ont la forme d'une ellipse.

11

10. Résonateur selon l'une des revendications 1 à 9, caractérisé par le fait que sa structure est monobloc et taillée dans une plaque de matériau d'épaisseur uniforme.

11. Résonateur selon la revendication 10, caractérisé par le fait que le matériau d'épaisseur uniforme est une lame de quartz entretenue sur une de ses fréquences de résonance par effet piézoélectrique.

12. Résonateur selon la revendication 11, caractérisé par le fait qu'il est obtenu par usinage à ultrasons en une seule opération à l'aide d'un outil unique.


Patentansprüche

1. Zungen- oder Stabresonator (1), welcher eine Biegeschwingung ausführt, der an jedem Ende eine Befestigungsvorrichtung (2) aufweist und dessen Schwingungsentkoppelung durch zwischen den Befestigungsvorrichtungen (2) und dem Stab (1) angeordnete Schwungmassen (3) erzielt wird, dadurch gekennzeichnet, daß jede Schwungmasse (3) in der Schwingungsebene des Stabes (1) schwenkbar gelagert ist gemäß einer Drehbewegung um eine orthogonal zur Schwingungsebene des genannten Stabes (1) liegende Achse und durch ein biegsames Element (4) mit ihren Befestigungsvorrichtungen verbunden ist.

2. Resonator gemäß Anspruch 1, dadurch gekennzeichnet, daß die Schwungmassen (3) einen konvexen Umriß aufweisen, mit den Befestigungselementen (2) durch ihre dem Stab (1) gegenüberliegende Seite verbunden und so ausgeführt sind, daß sie als Reaktion auf die Schwingbewegung des Stabes (1) eine Drehbewegung ausführen, wobei die Rotationsachse der Massen (3) senkrecht zur Schwingungsebene des Stabes (1) und auf Höhe biegsamer Elemente (4) gelegen ist.

3. Zungen- oder Stabresonator (1), welcher eine Biegeschwingung ausführt und ein freies Ende aufweist, und dessen Schwingungsentkoppelung durch eine zwischen einer Befestigungsvorrichtung (2) und dem Stab (1) angeordnete Schwungmasse (3) erzielt wird, dadurch gekennzeichnet, daß die Schwungmasse (3) schwenkbar in der Schwingungsebene des Stabes (1) gelagert ist gemäß einer Drehbewegung um eine orthogonal zur Schwingungsebene desgenannten Stabes (1) liegende Achse, wobei die Schwungmasse (3) durch ein biegsames Element (4) mit der Befestigungsvorrichtung (2) verbunden ist.

4. Resonator gemäß einem der Ansprüche 1 bis 3, dadurch gekennzeichnet, daß die Schwungmasse (3) mindestens zwei Grundmassen aufweist, die untereinander durch ein biegsames Element verbunden sind, wodurch die Rotation

12

jeder Grundmasse in der Schwingungsebene des Stabes (1) möglich wird.

5. Resonator gemäß einem der Ansprüche 1 bis 4, dadurch gekennzeichnet, daß die ligene Resonanzfrequenz der Schwungmassen (3) größer ist als die des schwingenden Stabes (1).

6. Resonator gemäß einem der Ansprüche 1 bis 5, dadurch gekennzeichnet, daß der Stab (1) so ausgelegt ist, daß er im Grundbiegemodus schwingt.

7. Resonator gemäß einem der Ansprüche 1 bis 5, dadurch gekennzeichnet, daß der Stab (1) so ausgelegt ist, daß er in einem Teilbiegemodus schwingt.

8. Resonator gemäß einem der Ansprüche 1 bis 7, dadurch gekennzeichnet, daß die Schwungmassen (3) in der Schwingungsebene des Stabes (1) die Form eines Rechtecks haben.

9. Resonator gemäß einem der Ansprüche 1 bis 7, dadurch gekennzeichnet, daß die Schwungmassen (3) in der Schwingungsebene des Stabes (1) die Form einer Ellipse haben.

10. Resonator gemäß einem der Ansprüche 1 bis 9, dadurch gekennzeichnet, daß er eine Monoblockstruktur aufweist und aus einer Materialplatte gleichmäßiger Dicke herausgeschnitten ist.

11. Resonator gemäß Anspruch 10, dadurch gekennzeichnet, daß das Material gleichmäßiger Dicke ein durch piezoelektrischen Effekt auf einer ihrer Resonanzfrequenzen gehaltene gehaltener Quarzstab ist.

12. Resonator gemäß Anspruch 11, dadurch gekennzeichnet, daß er durch Ultraschalbearbeitung in einem einzigen Arbeitsgang mit Hilfe eines einzigen Werkzeuges hergestellt wird.


Claims

1. Resonator of the type comprising a blade, or beam, (1), vibrating under flexion, comprising fixing means (2), at each end and whose vibratory decoupling is obtained by inertia masses (3) disposed between the fixing means (2) and the beam (1), characterized in that each inertia mass (3) is mounted for oscillating in the vibration plane of the beam (1) with a movement of rotation about an axis orthogonal to the vibration plane of said beam (1) and is connected to its fixing means by a flexible element (4).

2. Resonator as claimed in claim 1, characterized in that the inertia masses (3) have a convex contour, are connected to the fixing elements (2) by their face opposite the beam (1) and are arranged to be driven with a rotary movement in response to the vibratory movement of the

## 13

beam (1), the axis of rotation of the masses (3) being pependicular to the vibration plane of the beam (1) and situated at the level of flexible elements (4).

3. Resonator of the type comprising a blade or beam, (1) vibrating under flexion and having one free end, and whose vibratory decoupling is obtained by an inertia mass (3) disposed between a fixing means (2) and the beam (1), characterized in that the inertia mass (3) is mounted for oscillating in the plane of vibration of the beam (1) with a movement of rotation about an axis orthogonal to the vibration plane of said beam (1), the inertia mass (3) being connected to the fixing means (2) by a flexible element (4).

4. Resonator as claimed in one of claims 1 or 3, characterized in that the inertia mass (3) comprises at least two elementary masses connected together by a flexible element allowing rotations of each elementary mass in the vibration plane of the beam (1).

5. Resonator as claimed in one of claims 1 to 4, characterized in that the natural resonance frequency of the inertia masses (3) is higher than that of the vibrating beam (1).

6. Resonator as claimed in one of claims 1 to 5, characterized in that the beam (1) is arranged for vibrating in a fundamental flexion mode.

7. Resonator as claimed in one of claims 1 to 5, characterized in that the beam (1) is arranged for vibrating in a partial flexion mode.

8. Resonator as claimed in one of claims 1 to 7, characterized in that, in the vibration plane of the beam (1), the inertia masses (3) have the form of a rectangle.

9. Resonator as claimed in one of claims 1 to 7, characterized in that, in the vibration plane of the beam, the inertia masses (3) have the form of an ellipse.

10. Resonator as claimed in one of claims 1 to 9, characterized in that it has a one piece structure being cut out from a slab of material of uniform thickness.

11. Resonator as claimed in claim 10, characterized in that the material of uniform thickness is a quartz beam kept on one of its resonance frequencies by piezoelectric effect.

12. Resonator as claimed in claim 11, characterized in that it is obtained by ultrasonic machining in a single operation using a single tool.

FIG 1

FIG 2

FIG 3

FIG 4

FIG 5a

FIG 5b

FIG 6c

FIG 6a

FIG 6b

FIG 8

FIG 9a

FIG 9b

FIG 7

FIG 10